(19) Europäisches Patentamt
European Patent Office
Office européen des brevets

(11) EP 3 217 420 A1

(12) **EUROPEAN PATENT APPLICATION**

(43) Date of publication:
**13.09.2017 Bulletin 2017/37**

(51) Int Cl.:
***H01J 37/28*** *(2006.01)* ***G01N 23/225*** *(2006.01)*

(21) Application number: **16000567.4**

(22) Date of filing: **09.03.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Carl Zeiss Microscopy Ltd.**
**Cambridge CB1 3JS (GB)**

(72) Inventor: **Hill, Edward**
**Huntingdon, Cambridgeshire PE29 1WZ (GB)**

(74) Representative: **Diehl & Partner GbR**
**Patentanwälte**
**Erika-Mann-Strasse 9**
**80636 München (DE)**

# (54) METHOD, ANALYSIS SYSTEM AND COMPUTER PROGRAM PRODUCT FOR SEMI-AUTOMATED X-RAY ELEMENTAL ANALYSIS USING A PARTICLE MICROSCOPE

(57) The invention relates to a system including a data analysis system for interactively generating elemental local composition data of an object depending on photon radiation data acquired by using a charged particle microscope, and a method of operating said system. A plurality of local spectral data sets (72) are read, each being indicative of an energy spectrum of photon radiation emitted in response to irradiation by a charged particle beam. Each of the local spectral data sets represents a measurement performed in a respective measurement region of the object. Two or more of the plurality of local spectral data sets are combined to obtain combined spectral data (71). The combined spectral data are then evaluated to extract a list of candidates (80-84) for determing the elements which cause emission line peaks in the respective local spectral data set. Additionally or alternatively, energy values (76, 77, 78) or energy ranges (73,74,75) areselected based on the combined spectral data for efficient background subtraction for each of the local spectral data sets.

71
Al
83
Cu
C
82
73
74
Cu
81
80
75
Cu
84
Intensity [a.u.]
2
4
6
8
10
12
14
16
18
20
Energy [keV]
79
Cu
Cu
72
Cu
76
77
78
94
Energy [keV]
70

Fig. 4

EP 3 217 420 A1

## Description

### Field

The present invention relates generally to a data analysis system and a charged particle microscope. The data analysis system is configured for automated or interactive quantitative analysis of X-ray data and/or cathodoluminescence data acquired by using the charged particle microscope. More specifically, the data analysis system is configured for background subtraction, quantitative and qualitative analysis based on combined data formed by combining data from a plurality of measurement regions on the sample.

### Background

Scanning electron microscopes have been in use for many years for X-ray microanalysis of mineral samples. To determine which minerals are present in mines, a sample rock is typically disaggregated into small granules, e.g. by crushing using a mortar and pestle. The granules are fixed in epoxy in a mold, which is introduced into the vacuum chamber of a scanning electron microscope. In mines, the processing of ores may involve the comminution of the rock into fine powders from which the value is then recovered. To understand the relationship between the target minerals to the other constituent minerals in the rock, and to assess the quality of the recovery process, powders sampled at different stages in the recovery process may be mounted in expoxy and studied in the scanning electron microscope.

Once the sample is loaded into the vacuum chamber, a process called X-ray spectroscopy is performed. One type of X-ray spectroscopy is "energy dispersive spectroscopy" (EDS). Another type is "wavelength dispersive spectroscopy" (WDS). These techniques include measuring the energy of X-rays coming from the sample in response to electron beam irradiation. The impinging electron beam on the sample causes electrons from inner shells to be ejected, resulting in the emission of characteristic X-rays.

The measured X-ray data is plotted in a histogram to form an energy spectrum. In particular in the case of EDS analysis, the spectrum can be compared to known spectra of various elements or minerals to determine which elements or minerals are present in the sample. The spectrum is composed of the intensity peaks for the individual chemical elements present in the analysis. The concentration of the elements present in any one analysis is characteristic to a mineral and may be used to determine its presence. This measurement is repeated for each of a plurality of locations of impingement of the electron beam on the sample, typically resulting in a large number of spectra that need to be analyzed. Thereby, a compositional map of the object's surface can be obtained.

It has been shown that accurate determination of the background for each of the spectra is critical to obtaining precise results. However, applying precise techniques for background estimation for each of the large number of spectra usually is a time-consuming operation. Also, the fitting process for each of the large number of spectra is a time-consuming operation.

Therefore, a need exists to provide a method and an apparatus, which allows efficient photon spectroscopy using a particle microscope.

### Summary

Embodiments provide a method of operating a system. The system may include a data analysis system for interactively generating elemental composition data of an object. The elemental composition data may be determined depending on photon radiation data acquired by using a charged particle microscope. The method may include reading and/or generating, by the data analysis system, a plurality of local spectral data sets. Each of the local spectral data sets may be indicative of an energy spectrum of photon radiation emitted in response to irradiation by a charged particle beam. Each of the local spectral data sets may represent a measurement performed in a respective measurement region of the object. The measurement regions of the local spectral data sets may be mutually non-identical and/or mutually non-overlapping. The method may further include combining two or more of the local spectral data sets. The combining of the data of the local spectral data sets may be performed to obtain combined spectral data. The method may include determining processing parameter data depending on at least a portion of the combined spectral data. The method may include determining, for each of a number of the measurement regions, separate local composition data, depending on at least a portion of the local spectral data set of the respective measurement region. The composition data of the local spectral data sets may further be determined depending on the processing parameter data.

The data analysis system may be a computer system. The computer system may include one or a combination of the following components: a processor, a storage system, an output device and/or an input device. The output device may be a display.

The charged particle microscope may include an electron microscope and/or a focused ion beam microscope. The electron microscope may include a scanning electron microscope and/or a transmission electron microscope. The transmission electron microscope may be operable as a scanning transmission electron microscope. The focused ion beam microscope may include a gas field ion source, a plasma ion source and/or a liquid metal ion source. The focused ion beam microscope may be a noble gas ion microscope, in particular a helium ion microscope. The charged particle beam may be one or a combination of an electron beam and an ion beam. The ion beam may be a noble gas ion beam such as a helium beam.

The charged particle microscope may include a particle optical system, which is configured to focus the charged particle beam on the object surface. The charged particle microscope may include a spectrometer for detecting photon radiation emitted from the object in response to irradiation by the charged particle beam. The spectrometer may include an energy dispersive X-ray spectrometer detector (EDS detector) and/or a wavelength dispersive X-ray spectrometer detector (WDS detector). Additionally or alternatively the photon spectrometer may include a cathodoluminescence spectrometer.

For each of the measurement regions, energy-resolved detection of the photon radiation may be performed to acquire a local spectral data set for the respective measurement region. Each of the local spectral data sets may be indicative of, in particular may include, an energy spectrum of photon radiation. The energy spectrum may represent photon intensity as a function of energy. The photon radiation may be X-ray radiation and/or cathodoluminescence radiation. The energy may be expressed in energy units, such as electron volts or wavelength. The photon intensity may be expressed in arbitrary units or counts per time interval of defined length.

The measurement regions may be sequentially irradiated using the charged particle beam. One or more, or all of the measurement regions may represent a dwell point of the charged particle beam. For one or more of the measurement regions, each of the measurement region may represent two or more dwell points.

At each of the dwell points, the charged particle beam may be held stationary during a dwell time. A dwell point may represent a scanning position of a scanning process.

At least one measurement region may represent a portion of a scanning path, which is continuously scanned by the charged particle beam (i.e. without being dwelled). For such a measurement region, the local spectral data set may be formed by combining or summing the data collected over the portion of the scanning path.

Two or more, or all of the read and/or generated local spectral data sets may be combined to obtain the combined spectral data. For each of the local spectral data sets which are combined, a portion or all of the data of the respective local spectral data set may be used for determining the combined spectral data. The combined spectral data may depend on further data, in particular on data of detectors of the charged particle apparatus, which are configured to detect particles and/or radiation. The combined spectral data may be indicative of, in particular may include, an energy spectrum of photon radiation. The energy spectrum may represent photon intensity as a function of energy. The photon radiation may be X-ray radiation and/or cathodoluminescence radiation. The combined spectral data may be indicative of, in particular may include, an energy spectrum of a total photon radiation emitted from all of the measurement regions based on which the combined spectral data is determined.

By way of example, the local spectral data sets include photon intensity values for a plurality of energy channels. The combining of the local spectral data sets may include summing the local spectral data sets channel-by-channel. The sum may be a weighted sum. Generally, the combining of the data of the local spectral data sets may include combining, for each of a plurality of energy values and/or energy ranges, photon intensity values of the local spectral data sets, which correspond to the respective energy value or energy range. The energy values may be different from each other. The energy ranges may be non-identical or non-overlapping. Combining the photon intensity values may include summing and/or averaging the photon intensity values. The sum or average may be a weighted sum or a weighted average.

The processing parameter data may be determined depending on at least a portion of the combined spectral data. The processing parameter data may be determined automatically and/or interactively. The interactive determination of the processing parameter data may be performed by using a graphical user interface of the data analysis system.

The method may further include determining, for each of a number of the measurement regions, separate local composition data. The number of the measurement regions, for which the composition data is determined, may be two or more. The number of measurement regions, for which the local composition data are determined, may be part of, may be overlapping with, may correspond to, or may include the two or more measurement regions based on which the combined spectral data are determined. For each of the number of measurement regions, the same or substantially the same processing parameter data may be used for determining the respective local composition data. Alternatively, for each of the number of measurement regions, a respective portion of the processing parameter data may be used for determining the respective local composition data. For at least two of the measurement regions, the respective portions of the processing parameter data may be different.

Determining the local composition data may include a quantitative and/or a qualitative analysis for one or more or all emission line peaks of the local spectral data set. An emission line peak may be defined as a peak, which is caused by a characteristic line emission of at least one element.

By way of example, the local composition data includes one or more elements, which are present in the respective measurement region. Additionally or alternatively, the local composition data may include one or more minerals or one or more mineral classes, which are present in the respective measurement region. Additionally or alternatively, the local composition data may include content values for one or more elements, content values for one or more minerals and/or content values for one or more mineral classes. The content may be expressed in units of weight percent or atomic percent.

According to an embodiment, the processing parameter data are indicative of one or more elements. The elements may be determined depending on at least a portion of the combined spectral data.

Determining the one or more elements may include determining an approximation for at least a portion of the energy spectrum of the combined spectral data. The approximation may be determined after or without background correction of the combined spectral data. The background correction may be performed using a background estimate.

The approximation may be determined depending on one or more reference spectra. Determining the approximation may include combining two or more of the reference spectra. Determining the approximation may include determining a weighted sum of two or more of the reference spectra. Each of the reference spectra may be pre-stored. Each of the reference spectra may correspond to one element or to one predefined composition consisting of two or more elements. The reference spectra may be determined by using measurement data and/or by performing simulations. Determining the approximation may include performing a fitting operation to fit the approximation to at least a portion of the combined spectral data.

The determining of the elements may include determining for each of the elements, whether the combined spectral data, in particular the peaks or emission line peaks of the combined spectral data, indicate that the respective element is present in the object or at least indicates a significant probability that the respective element is present in the object.

The data analysis system may be configured to determine whether the probability is significant depending on a probability measure, in particular depending on a predetermined threshold for the probability measure. By way of example, if the probability measure exceeds a predefined threshold, the probability that the element is present is defined to be significant. The probability measure may be a deviation of the approximation from at least a portion of the energy spectrum of the combined spectral data. The deviation may be a root-mean-square deviation. The approximation may be determined depending on an assumption that one or more elements are present in the object.

One or more elements which have a significant probability that each of the elements is present may be deemed to indicate that one or more further specific elements have a significant probability of being present in the object.

According to a further embodiment, for each of the number of measurement regions, the determining of the composition data comprises using the one or more elements, for which the processing parameter data are indicative of, as a list of candidates. The one or more elements may be used as a list of candidates for determining elements which are present in the respective measurement region. For each of the number of local spectral data sets, the one or more elements may be used as a list of candidates for determining an approximation to at least a portion of the energy spectrum of the respective local spectral data set.

The approximation may be determined after or without background correction of the local spectral data set. The background correction may be performed using a background estimate. The background estimate may be determined depending on at least a portion of the processing parameter data. The approximation may be determined depending on, or as a combination of, one or more reference spectra. Each of the reference spectra, which are used for determining the approximation, may correspond to one or more elements. Each of the elements may be contained in the list of candidates. The elements of the reference spectra may be limited or substantially limited to the list of candidates. Determining the approximation may include performing a fitting operation to fit the approximation to at least a portion of the local spectral data set.

For each of the number of the measurement regions, the local composition data may include data which are indicative of one or more elements which are present in the respective measurement region. The list of candidates may be used for determining the data, which are indicative of the elements present in the measurement region. The determining of the data which are indicative of the elements present in the measurement region may be limited or substantially limited to the list of candidates. According to a further embodiment, the method further includes storing, by the data analysis system, the processing parameter data in a storage system.

According to a further embodiment, the processing parameter data are indicative of one or more energy values and/or energy ranges.

For each of the number of measurement regions, the local composition data may be determined depending on the one or more energy values and/or energy ranges. The same or substantially the same one or more energy values and/or one or more energy ranges may be used for determining the local composition data for each of the number of measurement regions.

The data analysis system may be configured to determine the at least one energy value or the at least one energy range automatically and/or interactively. The interactive determination may be performed by using a graphical user interface. The graphical user interface may be configured to display a graphical representation of at least a portion of the combined spectral data. The graphical user interface may further be configured to receive user input indicative of the at least one energy value and/or of the at least one energy range.

Each of the energy values and/or energy ranges may be free or may be substantially free from peaks of the combined spectral data and/or may be free or substantially free from emission line peaks of the combined spectral data. The peaks and/or emission line peaks may have been detected by performing interactive or automated peak detection.

Each of the energy values and/or energy ranges may be free or substantially free from absorption edges in the combined spectral data. The absorption edges may be caused by absorption of photons, such as X-rays, within the object. The absorption edges may be detected using the data analysis system by performing automated or interactive edge detection.

Additionally or alternatively, each of the energy values and/or energy ranges may be free or substantially free from energy-dependent variations of the photon intensity of the combined spectral data caused by the spectrometer. The energy-dependent variation may be at least partially caused by an energy-dependent detector efficiency. According to a further embodiment, the processing parameter data may include peak data representing parameters of one or more or all peaks of the combined spectral data. The peaks may be emission line peaks and/or peaks which have been detected using the data analysis system by performing automated or interactive peak detection. The parameters of a peak may include one or a combination of (1) a centroid energy of the peak, (2) a width of the peak, which may be measured as FWHM i.e. full width at half maximum, and (3) an energy range over which the peak extends.

According to a further embodiment, the method further comprises performing automated and/or interactive peak detection for detecting one or more peaks of the combined spectral data. The determining of the processing parameter data may be performed depending on the one or more detected peaks. The detected peaks may represent at least part of the emission line peaks of the combined spectral data.

The peak detection may include processing or scanning data values of the combined spectral data. The peak detection may be performed depending on one or more predefined peak detection parameters. By way of example, the predefined peak detection parameters may include a minimum level for a peak to noise ratio, a minimum value for a peak width and/or a minimum value for a peak area.

The interactive peak detection may include displaying, via the graphical user interface, a graphical representation of at least a portion of the combined spectral data. The graphical representation may represent an energy spectrum. The interactive peak detection may further include receiving, via the graphical user interface, user input indicative of one or more peaks of the combined spectral data. By way of example, the user input may be indicative of a centroid energy of the peak and/or may be indicative of an energy range over which the peak extends.

According to a further embodiment, the method further includes performing interactive and/or automated detection of absorption edges of the combined spectral data. The processing parameter data may be determined depending on the one or more detected absorption edges.

The detection of the absorption edges may include processing or scanning data values of the combined spectral data. The detection of the absorption edges may be performed depending on one or more predefined edge detection parameters. By way of example, the predefined edge detection parameters include a minimum level for an edge height and/or a maximum level for a width of the edge.

The interactive detection of the absorption edges may include displaying, via the graphical user interface, a graphical representation of at least a portion of the combined spectral data to the user. The interactive detection of the absorption edges may further include receiving, via the graphical user interface, user input indicative of one or more absorption edges of the combined spectral data. By way of example, the user input may be indicative of an energy of the absorption edge and/or may be indicative of an energy range over which the absorption edge extends.

The method may further include determining the processing parameter data depending on the detected peaks and/or depending on the detected absorption edges.

According to a further embodiment, for each of the number of measurement regions, the determining of the local composition data comprises determining a background estimate for a background correction. The background estimate may be determined for at least one or more emission line peaks of the local spectral data set of the respective measurement region. For each of the number of measurement regions, the background estimate may be determined depending on at least a respective portion of the processing parameter data. At least for two of the measurement regions, respective portions of the processing parameter data may be different.

The background estimate may include one or more estimated background values, each of which representing the background estimate at a different energy. For each of the background values, the background correction may include subtracting the background value from a photon intensity value of the local spectral data set, wherein the background value and the photon intensity value correspond to a same or substantially to a same energy. For at least one emission line peak of the local spectral data set, the background estimate may represent an approximation for a separation between photon line emission and non-line photon radiation.

The background estimate may represent or substantially represent bremsstrahlung and/or non-line photon radiation for one or more different energy values. The non-line photon radiation may be caused by bremsstrahlung. The bremsstrahlung may be caused by the scattering of charged particles of the charged particle beam at the object. The non-line photon radiation may be influenced by statistical noise, by an energy dependence of a detector efficiency of the photon spectrometer and/or by an energy dependence of a photon absorption of the object. The background estimate may be corrected or uncorrected for the energy-dependent detector efficiency of the photon detector. Additionally or alternatively, the background estimate may be corrected or uncorrected for the energy-dependent absorption of the emitted photon by the object. A background estimate which is corrected for the energy-dependent absorption may show absorption edges.

According to a further embodiment, for each of the number of measurement regions, the background estimate is determined depending on one or more spectrum data points of the local spectral data set of the respective measurement region. For each of the number of measurement regions, the spectrum data points may be determined using at least a respective portion of the processing parameter data. The respective portions may be identical or non-identical. The processing parameter data may include or may be indicative of one or more energy values and/or one or more energy ranges. The spectrum data points of the local spectral data set may be determined depending on the one or more energy values and/or the one or more energy ranges. The one or more spectrum data points may represent photon radiation emitted at the one or more energy values.

According to a further embodiment, the determining of the local composition data of the number of measurement regions comprises performing, depending on at least a portion of the processing parameter data, background modeling, background interpolation, background extrapolation and/or convolution filtering. Thereby, the background estimate may be obtained. The portion of the processing parameter data may be indicative of or may include the one or more energy values and/or the one or more energy ranges.

Performing the background modeling may include comparing a background function with at least a portion of the photon intensity values of the local spectral data set. The portion may represent one or more fitting points. The comparing may include fitting the background function to at least a portion of the photon intensity values. The fitted background function may represent a background estimate which can be used for background correction. Selecting the portion of the photon intensity values from the local spectral data set may be performed depending on at least a portion of the processing parameter data, in particular depending on the one or more energy values. The portion of the photon intensity values may represent photon radiation emitted at the one or more energy values.

The background function may depend on fitting parameters. The fitting procedure may produce values for at least a portion of these fitting parameters. The background function may represent or may depend on the Kramers term.

The background interpolation and/or extrapolation may be linear or non-linear. The interpolation and/or extrapolation may interpolate and/or extrapolate at least a portion of the photon intensity values of the local spectral data set. The portion of the photon intensity values may be determined depending on at least a portion of the processing parameter data. Determining the portion of the photon intensity values from the local spectral data set may be performed depending on the processing parameter data, in particular depending on the one or more energy values and/or depending on the one or more energy ranges. The portion of the photon intensity values may represent photon radiation emitted at the one or more energy values.

Additionally or alternatively, the determining of the local composition data comprises performing convolution filtering. The convolution filter may be a digital convolution filter. The convolution filter may be a zero-area correlator. By way of example, the convolution filter is a "Top-Hat" filter. The convolution filter may be determined depending on the processing parameter data.

An extent (or width) of the convolution filter may be determined depending on the processing parameter data. The extent of the convolution filter may depend on a width of an emission line peak, which may be measured as FWHM.

According to a further embodiment, the method further includes acquiring image data of a surface region of the object. The image data may show or represent a surface region of the object. The image data may be acquired by scanning the charged particle beam across the surface region. The method may further include identifying a portion of the surface region depending on the acquired image data. Identifying the portion of the surface region may include determining a lateral extent parallel or substantially parallel to an object plane of the charged particle microscope. Determining the extent may include determining lengths and widths of the portion of the surface region and/or determining a surface area of the portion of the surface region. Determining the portion of the surface region may include determining an image portion of an image, wherein the image is represented by the image data. The image may represent and/or show the surface region. The image portion may represent and/or show the portion of the surface region. The combining of the local spectral data sets may be performed limited or substantially limited to local spectral data sets acquired within the identified portion of the surface region.

The image data may have compositional contrast. The compositional contrast may be defined as a contrast based on an average atomic number. The identifying of the portion of the surface region may be performed depending on the compositional contrast.

The acquiring of the image data may comprise detecting particles and/or radiation produced in response to the scanning of the charged particle beam. The image data may be determined depending on the detected particles and/or radiation. Detecting the particles may include selectively detecting backscattered particles of the charged particle beam which are backscattered at the object. By way of example, the charged particle microscope is configured to selectively detect backscattered electrons and/or backscattered ions. Additionally or alternatively, the detecting of the particles includes selectively detecting secondary particles. Secondary particles may be defined as particles of the object, which are released from the object in response to irradiation with the charged particle beam. By way of example, the charged particle microscope is configured to selectively detect secondary electrons.

Detecting the radiation may include selectively detecting radiation emitted from the object, such as selectively detecting cathodoluminescence light radiation and/or selectively detecting X-ray radiation. The cathodoluminescence light radiation and/or the X-ray radiation may be detected by using a spectrometer.

The identifying of the portion of the surface region may include applying, by the data analysis system, an image processing operation to the image data. The image processing operation may include a background subtraction filter. The background subtraction filter may include a threshold filter. The image processing operation may be sensitive to a compositional contrast of the image data. In particular, the image processing operation may filter the image data based on the compositional contrast. The data analysis system may perform a segmentation of the image, which is represented by the image data. The segmentation may include one or a combination of the following segmentation methods: a pixel-oriented method, an edge-oriented method, a region-oriented method, and a model-based method.

The image data may be acquired before, during or after the object is irradiated at the measurement regions. The measurement regions, based on which the combined spectral data are determined, may be selected depending on the identified portion of the surface region. In particular, the measurement regions, based on which the combined spectral data are determined, may be selected from measurement regions which are located within the identified portion of the surface region. Alternatively, the system may be configured to selectively irradiate the object at measurement regions within the identified portion of the surface region to acquire the local spectral data sets based on which the combined spectral data are determined.

Embodiments provide a computer program product comprising a machine-readable medium having stored thereon a program code which, when loaded and executed in a computer system, is adapted to perform the method according to any one of the preceding embodiments.

Embodiments provide a non-transitory computer-readable storage medium storing instructions, that when executed by a computer, cause the computer to perform a method of operating a system. The system may include a data analysis system for interactively generating elemental composition data of an object. The elemental composition data may be determined depending on photon radiation data acquired by using a charged particle microscope. The method may include reading and/or generating, by the data analysis system, a plurality of local spectral data sets. Each of the local spectral data sets may be indicative of an energy spectrum of photon radiation emitted in response to irradiation by a charged particle beam. Each of the local spectral data sets may represent a measurement performed in a respective measurement region of the object. The measurement regions of the local spectral data sets may be mutually non-identical. The method may further include combining two or more of the local spectral data sets. The combining of the data of the local spectral data sets may be performed to obtain combined spectral data. The method may include determining, for each of a number of the measurement regions, separate local composition data, depending on at least a portion of the local spectral data set of the respective measurement region. The composition data of the local spectral data sets may further be determined depending on the processing parameter data.

Embodiments provide a system comprising a data analysis system for generating local composition data of an object depending on photon radiation data acquired by using a charged particle microscope. The data analysis system may be configured for interactively or automatically reading and/or generating a plurality of local spectral data sets. Each of the plurality of local spectral data sets may be indicative of an energy spectrum of photon radiation emitted in response to irradiation by a charged particle beam generated by the charged particle microscope. Each of the local spectral data sets may represent a measurement performed in a respective measurement region of the object. The measurement regions of the local spectral data sets may be mutually non-identical. The system may be configured to interactively and/or automatically combine two or more of the plurality of local spectral data sets to obtain combined energy spectral data. The system may be configured to interactively and/or automatically determine processing parameter data depending on at least a portion of the combined spectral data. The system may be configured to interactively and/or automatically determine for each of a number of the measurement regions, separate local composition data, depending on at least a portion of the local spectral data set of the respective measurement region. The system may further be configured to interactively and/or automatically determine the composition data of the local spectral data sets depending on the processing parameter data.

The processing parameter data may be indicative of one or more elements. The system may be configured to use the one or more elements as a list of candidates for the determining of the local composition data.

The data analysis system may include a graphical user interface. The graphical user interface may be configured for a display of the data analysis system.

The determining of the processing parameter data depending on the combined spectral data may be performed in an interactive manner. The graphical user interface may be configured to display on the display a graphical representation of at least a portion of the combined spectral data. The graphical representation may represent a photon energy spectrum. The graphical user interface may further be configured to receive user input via the graphical user interface. The data analysis system may be configured to determine the processing parameter data depending on the user input. The user input may be indicative of at least one energy value and/or least one energy range. Each of the at least one energy value and/or the at least one energy range may be free or substantially free from emission line peaks and/or free from absorption edges of the combined spectral data. Additionally or alternatively, the user input may be indicative of one or more elements.

According to a further embodiment, the data analysis system further includes a graphical user interface, which is configured to display a graphical representation of at least a portion the combined spectral data. The combined spectral data may be displayed in graphical relation to a graphical representation of at least a portion of the processing parameter data.

The graphical representations may be separated, i.e. non-overlapping, or at least partially overlapping. The graphical user interface may be configured so that the graphical relation between the graphical representation of the combined spectral data and the graphical representation of the processing parameter data is adjustable depending on user input. Depending on the adjustment, the data analysis system may generate or update at least part of the processing parameter data.

The graphical representation of the processing parameter data may include one or more indicators indicating one or more energy values and/or one or more energy ranges in the graphical representation of the combined spectral data. Each of the indicators may be user-adjustable and/or user-positionable.

According to a further embodiment, the system is further configured for interactively or automatically identifying a portion of a surface region of the object depending on image data acquired of the surface region. The image data may be acquired from the surface region of the object. The acquired image data may represent and/or show the surface region. The data analysis system may be configured so that the combining of the local spectral data sets is limited or substantially limited to local spectral data sets acquired within the identified portion of the surface region.

Interactively identifying the portion of the surface region may include displaying, by the graphical user interface, an image represented by the image data. The identifying of the portion of the surface region may further include receiving user input indicative of an image portion representing the portion of the surface region. In particular, the user input may define a graphical representation which is indicative of the image portion and which is displayed in graphical relation to the displayed image.

According to a further embodiment, the system further includes a particle beam microscope. For each of the plurality of measurement regions, the particle beam microscope may be configured to irradiate, the respective measurement region with the charged particle beam. Additionally or alternatively, the particle beam microscope may be configured to detect the photon radiation emitted in response to irradiation with the charged particle beam.

## Brief Description of the Drawings

The forgoing as well as other advantageous features of the disclosure will be more apparent from the following detailed description of exemplary embodiments with reference to the accompanying drawings. It is noted that not all possible embodiments necessarily exhibit each and every, or any, of the advantages identified herein.

FIG. 1 schematically illustrates a system comprising scanning electron microscope and a data analysis system for interactively generating data representing a composition of an object, according to an exemplary embodiment;

FIG. 2 schematically illustrates a sample, comprising object particles embedded in a resin matrix;

FIG. 3 schematically illustrates an X-ray spectrum comprising emission line peaks and a continuous background;

FIG. 4 schematically illustrates a window of a graphical user interface of the data analysis system which is shown in FIG. 1. The window shows an X-ray energy spectrum of combined spectral data and an X-ray spectrum of a first measurement region of the object;

FIG. 5 schematically illustrates an X-ray energy spectrum of a second measurement region of the object; and

FIGS. 6A and 6B schematically illustrate the determination of compositional data from an X-ray energy spectrum of a third measurement region of the object.

**Detailed Description of Exemplary Embodiments**

In the exemplary embodiments described below, components that are alike in function and structure are designated as far as possible by alike reference numerals. Therefore, to understand the features of the individual components of a specific embodiment, the descriptions of other embodiments and of the summary of the disclosure should be referred to.

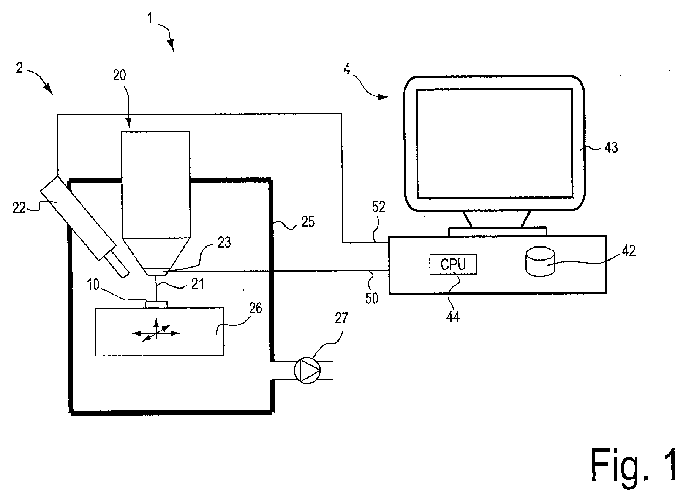

FIG. 1 illustrates a system 1 according to an exemplary embodiment. The system 1 includes a data analysis system 4 and a charged particle microscope 2. The data analysis system 4 is configured for generating analysis data from microscopic data of the charged particle microscope 2. In the exemplary embodiment, which is shown in FIG. 1, the charged particle microscope 2 is configured as a scanning electron microscope. However, it is also conceivable that the charged particle microscope is configured as a transmission electron microscope and/or as a focused ion beam microscope. The scanning electron microscope 2 comprises a particle optical system 20 for scanning a focused electron beam 21 across a surface of an object 10, which is disposed in a vacuum chamber 25. The vacuum chamber 25 is equipped with a vacuum pumping system 27 for maintaining a pre-determined vacuum pressure during measurements with the focused electron beam 21.

The object 10 is mounted on a positioning system 26. The positioning system 26 is disposed within the vacuum chamber 25 and configured to position the object 10 relative to the particle optical system 20 such that a region of interest on the object surface can be scanned by the electron beam 21. The positioning system 26 may be configured for translational and/or rotational positioning.

The scanning electron microscope 2 is equipped with a backscattered electron detector 23 (also denoted as BSE detector). The BSE detector 23 is in signal communication with the data analysis system 4 via signal line 50. The data analysis system 4 is configured to read detector signals of the BSE detector 23 and to generate image data depending on the signals of the BSE detector 23. Additionally or alternatively, the scanning electron microscope 2 may be equipped with other particle detector systems, such as a secondary electron detector.

The scanning electron microscope 2 is further equipped with an energy-dispersive spectrometer detector 22 (EDS detector). Additionally or alternatively, the scanning electron microscope may include a wavelength dispersive X-ray spectrometer detector (WDS detector).

When the electron beam 21 removes an inner shell electron from an atom of the object 10, characteristic X-rays are emitted when higher energy electrons fill the inner shell and release energy. The EDS detector 22 is configured for energy-resolved detection of the X-ray radiation resulting in an X-ray energy spectrum. The characteristic X-rays form emission line peaks in the X-ray energy spectrum. The X-ray energy spectrum can be used to analyze the chemical composition at the measurement region of the object. By performing measurements at a plurality of measurement regions, a map of the composition of the sample can be obtained.

The EDS detector 22 is in signal communication with the data analysis system 4 via signal line 52. The data analysis system 4 is configured to read detector signals of the EDS detector 22 and to generate the X-ray energy spectra depending on the signals of the EDS detector 22.

In the exemplary embodiment, which is illustrated in FIG. 1, the data analysis system 4 includes a computer system, which comprises a display 43, a storage system 42, and one or more processors 44. The storage system 42 may comprise internal storage units and/or may be configured to have access to external storage units. An external storage unit may be for example a network drive or a cloud storage unit. The data analysis system 4 further comprises a graphical user interface that resides in the storage system 42 and which is configured for a display screen of the display device 43.

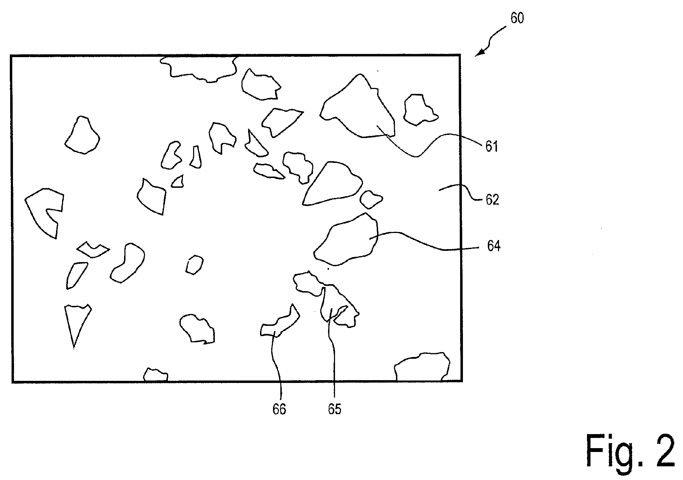

FIG. 2 illustrates an exemplary image 60 of a plurality of particles embedded in an epoxy matrix. This represents a typical object in the field of mineral analysis, where each of the particles is usually composed of one or more mineral grains. The image 60 is generated by the data analysis system 4 depending on BSE detector signals received from the charged-particle microscope 2. The intensity of a BSE image is primarily dependent on the average atomic number. Therefore, the BSE image has compositional contrast. The image 60 shows the particles of the object, such as particles 61, 64, 65 and 66 as bright regions, surrounded by a dark background 62. The dark background 62 represents regions of the object, where the resin matrix is present.

In order to determine the those object portions where particles are present the data analysis system applies a threshold filter to the image shown in FIG. 2. The threshold is configured so that pixel data values of the darker background 62, where only epoxy is present, are filtered out. Therefore, the threshold filter is sensitive to the compositional contrast of the BSE image. Additionally or alternatively, the data analysis system may apply a segmentation filter to the image. The segmentation may include one or a combination of the following segmentation methods: a pixel-oriented method, an edge-oriented method, a region-oriented method and a model-based method. Thereby, also the segmentation filter may be sensitive to the compositional contrast of the BSE image. Thereby, a portion of the surface region which is represented by the image 60 is automatically determined.

Additionally or alternatively, the data analysis system may be configured for interactive determination of the object portions, where the particles are present. In other words, a portion of the surface region, which is represented by the image 60 is determined in an interactive manner. Determining the object portions may include determining an extent of the object portions. The extent may be, for example, be measured by the length and/or width of the object portions and/or by the surface area of the object portions. The determination may be performed using a graphical user interface of the data analysis system 4.

After those image regions are determined where particles are present, the data analysis system controls the particle optical system 20 via signal line 51 so that EDS measurements are selectively performed on the particles' surfaces. Thereby, the time necessary for performing the EDS measurements can be considerably reduced, since time-consuming EDS measurements are avoided at positions where the epoxy matrix is present.

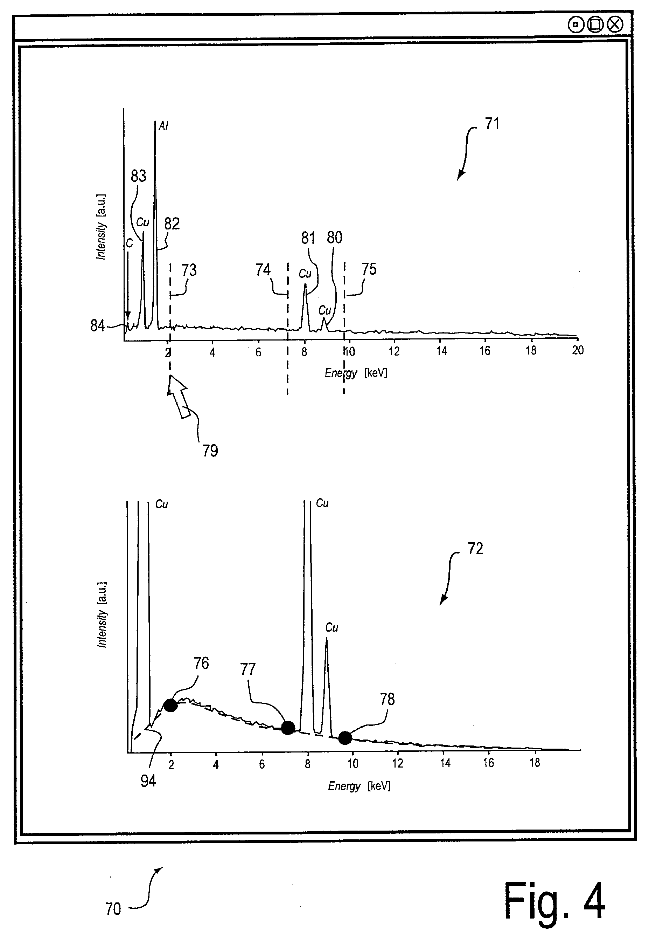

Further, selectively performing the EDS measurements at locations where particles are present has the effect that the number of elements which are present in a combined spectrum, which is formed by summing all X-ray spectra of the measurement regions, is reduced. As will be explained later with reference to FIGS. 4 to 6, this combined spectrum will be used for performing efficient and accurate background correction and compositional analysis for each of the X-ray spectra.

A further reduction in the number of elements in the combined spectrum can be achieved by excluding some of the object's particles, or portions of the particles, from further analysis, depending on the BSE image. By way of example, particles, or portions of particles, which have a similar average atomic number can be identified depending on the BSE image 60. In the BSE image 60 which is shown in FIG. 2, each of the particles 64, 65 and 66 appear darker, compared to the remaining particles, such as particle 61. Therefore, excluding the X-ray spectra, acquired from particles 64, 65 and 66 from further analysis, or selectively acquiring X-ray spectra only from the remaining particles, allows a further reduction of the number of elements in the combined spectrum.

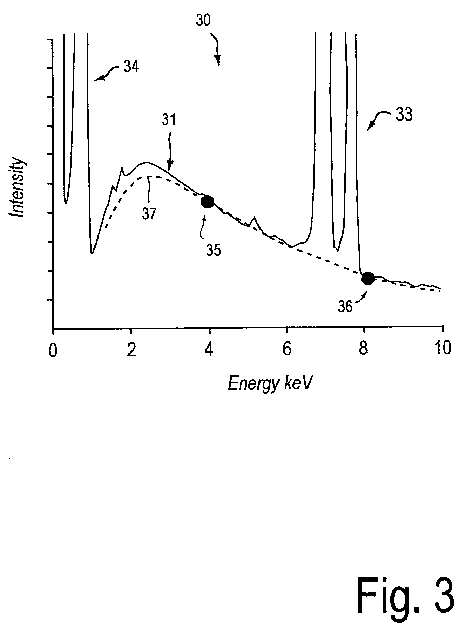

FIG. 3 illustrates exemplary background correction procedures for performing compositional analysis of an X-ray spectrum. The X-ray spectrum which is shown in FIG. 3 is acquired from a pure Cobalt sample by using the exemplary system 1, as illustrated in FIG. 1. The energy of the electron beam was 20 kV.

The spectrum shows Co L-emission line peaks 34 at energies below 1 keV and Co K-emission line peaks 33 at energies between 6 and 8 keV. The spectrum further shows a continuous background 31 which has a maximum at 2 keV and which is largely due to bremsstrahlung. In order to obtain quantitative measurements of the Co content within the sample, it is necessary to measure the intensity height of at least one of the peaks after the background has been subtracted.

It has been shown that in the energy range between 6 and 8 keV, in which the Co K-emission line peaks 33 are located, the following analytical expression *B(E)* can be accurately fitted to the background of the spectrum of FIG. 3:

$$B(E) = K_1 \cdot Z \cdot \frac{E_0 - E}{E} + K_2 \cdot Z \cdot \frac{(E_0 - E)^2}{E}$$

(Equation 1)

where $K_1$ and $K_2$ are constants, Z is the average atomic number at the measurement region and $E_0$ is the energy of the incident charged particles of the charged particle beam.

Equation 1 depends on the "Kramers" term $B_K(E)$:

$$B_K(E) = K_1 \cdot Z \cdot \frac{E_0 - E}{E}$$

(Equation 2)

In order to fit the analytical expression *B(E)* to the background of FIG. 3, it is necessary to determine at least two energy values in the spectrum depicted in FIG. 3, at which the background can be measured with high accuracy. It has been shown that for pure Co samples, a background estimate for the K-emission line peaks can be obtained with sufficient accuracy if the values for $K_1 \cdot Z$ and for $K_2 \cdot Z$ are determined by using two data points 35, 36 at energies of 4 keV and 8 keV as fitting points. This results in the background estimate 37 for the continuous background 31. As can be seen from FIG. 3, at energies between 6 and 8 keV, the background estimate 37 is sufficiently accurate for the K-emission line peaks 33.

Less accurate but still satisfactory results can be obtained by performing a linear interpolation between data point 35 and data point 36. It is further conceivable that extrapolation techniques or non-linear interpolation and/or extrapolation techniques are applied to obtain a background estimate. If the background is substantially constant, it is conceivable that determining one single energy value in the spectrum is sufficient for obtaining a satisfactory background estimate.

For the L-emission line peaks 34 shown in FIG. 3, it has been shown that the background is significantly influenced by the detector efficiency of the EDS detector. Hence, in order to perform a quantitative analysis for obtaining the concentration of Co within a sample, it is preferred to evaluate the K-emission line peaks 33. However, it is also conceivable that equation 1 is multiplied by an energy-dependent multiplication factor for correcting equation 1 for effects of detector efficiency.

It has further been shown for a number of samples of different compositions that the background in the energy range below 3 keV is typically significantly influenced by absorption of the X-rays within the sample, showing one or more absorption edges. It is conceivable that the background estimate $B(E)$ is multiplied by an energy-dependent multiplication factor for correcting the background estimate $B(E)$ for effects of absorption. The energy-dependent multiplication factor is dependent on the elements, which are present in the sample. The elements, which are present in the sample can be determined precisely or approximately by determining the peak centroids of at least some of the emission line peaks of the spectrum. The detected peak centroids can then be compared with entries in a database to determine one or more elements, which are present in the sample.

Additionally or alternatively, the background correction may be performed by applying a convolution filter to the spectral data. The convolution filter may be a digital convolution filter. The convolution filter may be, for example, a zero-area correlator, such as a "Top-Hat" filter. An extent of the convolution filter may be determined depending on or adapted to a width of an emission line peak. The width of the emission line peak may be measured as FWHM (full width at half maximum).

As has been discussed with reference to FIG. 2, for each of a plurality of measurement regions, a local spectral data set is acquired. Each of the local spectral data sets represents an energy spectrum of X-ray radiation, such as the spectrum shown in FIG. 3. Applying the background correction techniques, which were previously discussed with reference to FIG. 3, to each of these local spectral data sets is generally a time consuming task. Also, determining qualitative and quantitative information for each of the local spectral data sets based on pre-stored reference spectra of a wide range of elements is a time consuming task. Therefore, a need exists for a method and system to efficiently evaluate the local spectral data sets.

It has been shown that the efficiency of the analysis can be greatly increased if the local spectral data sets are combined to form combined spectral data. The combined spectral data are obtained by summing the X-ray energy spectra of the local spectral data sets, thereby forming combined spectral data, which represents a combined energy spectrum. The combined spectral data are then evaluated to extract processing parameter data, which can be used in the analysis of each of the local spectral data sets.

As is illustrated in FIG. 4, the graphical user interface of the data analysis system is configured to show a graphical representation 71 of the energy spectrum of the combined spectral data in a window 70 of the graphical user interface, which is displayed on a display (designated by reference number 43 in FIG. 1). As can be seen from the energy spectrum, a number of emission line peaks 80, 81, 82, 83 and 84 are visible indicating that the portion of the sample which is represented by all of the measurement regions contains the elements copper, alumina and carbon. The presence of carbon is due to contamination of the sample.

The data analysis system is configured to automatically or interactively determine an object composition list. The object composition list is configured to include one or more elements. For each of the elements in the object composition list, it has been determined, by using the data analysis system, that the combined spectral data indicates a presence of the respective element or at least indicates a significant probability that the respective element is present.

In order to determine which elements are to be included in the object composition list, the data analysis interactively or automatically determines an approximation to the emission line peaks of the combined spectral data. The approximation is determined depending on pre-stored reference spectra. Each of the reference spectra represents an X-ray energy spectrum of one element. It is also conceivable that one or more of the reference spectra represent X-ray energy spectra of a predefined composition of two or more elements. The reference spectra are stored in a library of the storage system (designated by reference number 42 in FIG. 1).

Determining the approximation includes fitting a weighted reference spectrum to at least a portion of the energy spectrum of the combined spectral data and/or fitting a weighted sum of two or more reference spectra to at least a portion of the combined spectral data. A reference spectrum is weighted with a weight factor by multiplying each of the intensity values of the reference spectrum with the weight factor. The approximation represents a best fit spectrum which is obtained by adjusting the weight factors assigned to the one or more reference spectra. Before the approximation is generated, background correction of the combined spectral data is performed. However, it is also conceivable that the approximation to the emission line peaks is determined without background correction.

If the approximation deviates from the combined spectral data by less than a predefined limit, the probability that the elements (on which the approximation is based) are present is determined to be significant. The limit may be a limit for a root-mean-square deviation. It is conceivable that one or more elements which have a significant probability that the respective element is present are deemed to indicate a significant probability that specific further elements are present.

By way of example, an element may be present in a significant amount only in few of the measurement regions. Although a strong contribution of this element may be measurable in each of these few measurement regions, the contribution to the combined spectral data may be comparatively small so that the presence of the element can not be determined with certainty depending on the combined spectral data.

However, as described in detail further below, since the object composition list is a list of candidates for each of the measurement regions, it has shown to be advantageous (albeit not necessary) to include elements into the object composition list, even if determination of their presence is not possible with a high degree of probability.

In the example, which is shown in FIG. 4, a weighted combination of reference spectra of copper, alumina and carbon provided a sufficiently accurate approximation to the combined spectral data. Therefore, for the object under inspection, the object composition list includes the entries copper, alumina and carbon.

The object composition list is used as a list of candidates for determining, for each of the individual measurement regions, one or more elements which cause the emission line peaks in the respective local spectral data set. Thereby, for each of the local spectral data sets, the step of determining the elements which generate the emission line peaks can be limited to the elements of the list of candidates. This way, laborious fitting routines are avoided which check for the presence of each or nearly each element in the periodic table. The list of candidates therefore represents processing parameter data, which are used for the compositional analysis of the local spectral data sets.

A further advantage is provided in that determination of the elements which cause the elemental peaks in the combined spectral data is mostly easier, compared to the local spectral data sets. The reason for this resides in the fact that the combined spectral data represent a high-count spectrum resulting in a high signal-to-noise ratio compared to the local spectral data sets.

Before the approximation is determined by fitting the weighted sum of the reference spectra, background correction of the combined spectral data is performed. The background correction is performed depending on one or more energy values, as has been described with reference to FIG. 3.

In order to determine the energy values for background correction, the data analysis system is configured to allow the user to select one or more energy values in an interactive manner. The energy values are selected so that they are free from the emission line peaks of the combined spectral data.

Specifically, as is illustrated in FIG. 4, the user can adjust, by using the mouse cursor 79, a position of each of the user-positionable indicators 73, 74, 75 relative to the graphical representation 71 of the combined spectral data. By positioning each of the indicators 73, 74 and 75, three energy values can be selected which are free from the emission line peaks 80, 81, 82 and 84 of the combined spectral data.

Alternatively, it is conceivable that the data analysis system is configured for automatic determination of the energy values. By way of example, the data analysis system is configured to perform peak detection on the combined spectral data. Depending on the detected peaks, the data analysis system may further be configured to automatically determine one or more energy values so that each of the energy values is free from the detected peaks. Peak detection may, for example, be performed by applying a convolution filter to the combined spectral data.

It has been shown that automatic or interactive selection of the energy values is facilitated if the number of elements which cause the emission line peaks in the combined spectral data is low. Hence, by reducing the number of elements, which contribute to the emission lines of the combined spectral data, by using any one of the techniques which were previously described with reference to FIG. 2, more accurate and reliable results can be obtained.

It has further been found that the energy values, which are selected based on the combined spectral data, can be used for efficient background subtraction for each of the local spectral data sets. Specifically, in the later analysis of the local spectral data sets, the fitting points for determining the background estimate will be located at energies which correspond to the energy values determined based on the combined spectral data. Thereby, it is ensured that in the analysis of each of the local spectral data sets of the individual measurement regions, the data points will be free from emission line peaks of the respective local spectral data set.

Hence, it is not necessary to perform a separate analysis for each individual local spectral data set in order to select appropriate energy values for background correction. A further advantage is provided in that based on the combined spectral data, the energy values for background subtraction can mostly be determined in a more reliable way, since the combined spectral data have a higher signal-to-noise ratio compared to the local spectral data sets.

The three energy values, which are determined by positioning the indicators 73, 74 and 75 therefore represent processing parameter data, which are used for background correction of the local spectral data sets. The energy values are stored in the storage system 42 (shown in FIG. 1) of the data analysis system.

As is illustrated in FIG. 4, the graphical user interface is configured to display in the window 70 a graphical representation 72 of an energy spectrum of a local spectral data set of a first measurement region.

The graphical user interface further displays, in graphical relation to the graphical representation 72 of the local spectral data set, graphical representations 76, 77 and 78 of spectrum data points. The energy values of the spectrum data points correspond to the energy values which have been defined by positioning the indicators 73, 74 and 75 in the graphical representation 71 relating to the combined spectral data. The spectrum data points are used as fitting points for determining the background estimate for the local spectral data set. Specifically, by fitting Equation 1 to these spectrum data points, the background estimate is determined for the local spectral data set. The graphical user interface is configured to display a graphical representation 94 of the background estimate in graphical relation to the graphical representation 72 of the energy spectrum.

Additionally or alternatively, it is conceivable that the background estimates for the combined spectral data as well as the local spectral data sets are determined by using techniques such as interpolation, extrapolation and/or convolution filtering. By way of example, two energy values, are determined by positioning two or more indicators, such as the indicators 73 and 74 shown in FIG. 4, so that the corresponding energy values are indicative of a width of an emission line peak of the combined spectral data. Thereby, an energy range is defined which represents processing parameter data, which can be used for background correction of the local spectral data sets. Specifically, a convolution filter, which serves for background correction may be determined depending on the determined energy range. By way of example, a top hat filter is used for background correction and an extent of the top hat filter is adapted to the width of the emission line peak represented by the determined energy range.

Returning to the exemplary embodiment which is illustrated in FIG. 4, in order to determine a background estimate for background correction of the local spectral data set, the data analysis system fits the analytical expression $B(E)$ of Equation 1 to the spectrum data points, which correspond to graphical representations 76, 77 and 78. Then, the data analysis system displays, via the graphical user interface, the graphical representation 80 of the background estimate in graphical relation to the graphical representation 72 of the energy spectrum of the local spectral data set. Thereby, it is possible for the user to see, whether the energy values of the processing parameter data, which have been selected by positioning the indicators 73, 74 and 75 lead to a background estimate, which sufficiently approximates the background in the energy spectrum of the local spectral data set.

After the background estimate for the energy spectrum of the local spectral data set of the first measurement region has been determined, the local spectral data set can be corrected for background by subtracting the background estimate from the X-ray intensity values of the energy spectrum.

The graphical user interface is configured so that in a same manner, the background estimate of one or more further selected measurement regions are displayed. This allows the user to check for a number of selected measurement regions whether the energy values selected by means of indicators 73, 74 and 75 lead to sufficiently accurate background estimates. The measurement regions may be selected interactively through the graphical user interface.

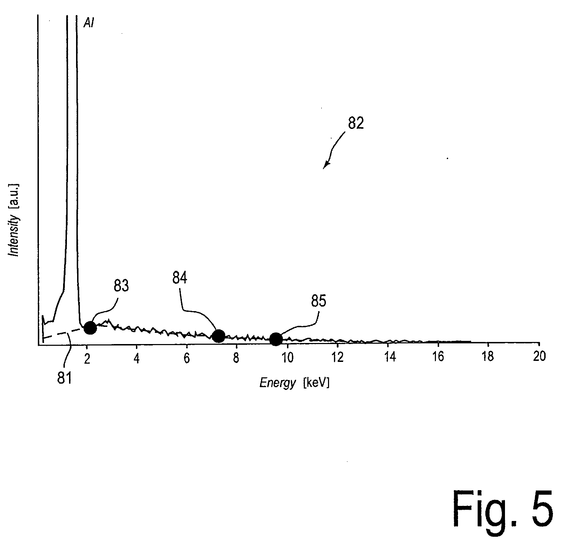

FIG. 5 illustrates a graphical representation 82 of an energy spectrum of a local spectral data set of a second measurement region which is displayed by the graphical user interface. As can be seen by comparing the graphical representation 82 with the graphical representation 72 shown in FIG. 4, the second measurement region has a different composition compared to the first measurement region. In the local spectral data set shown in FIG. 5, only alumina line emission peaks are present.

Also for the local spectral data set of the second measurement region, the data analysis system automatically determines the spectrum data points indicated by graphical representations 83, 84 and 85 according to the energy data values, which have been selected by positioning the indicators 73, 74 and 75 (shown in FIG. 4). Then, a background estimate, indicated by graphical representation 81, is calculated by fitting the analytical expression of Equation 1 to the spectrum data points. This allows determination of a background corrected X-ray spectrum for the second measurement region.

After the background correction has been performed for the local spectral data sets of all measurement regions, the data analysis system proceeds by determining qualitative compositional information for each of the measurement regions.

For each of the background corrected local spectral data sets, the data analysis system computes an approximation to the respective local spectral data set based on the reference spectra, which are stored in the storage system (designated by reference number 42 in FIG. 1). This is performed in the same way as has been described above for the combined spectral data. However, for the local spectral data sets, the elements of the reference spectra, depending on which the approximation is formed, are selected from the object composition list, which has been generated depending on the combined spectral as described in connection with FIG. 4.

In this way, the compositional analysis of the local spectral data sets is performed in a more time-efficient manner, since for all those elements, which are not included in the object composition list, it is not necessary to check, whether these elements contribute to the local spectral data set.

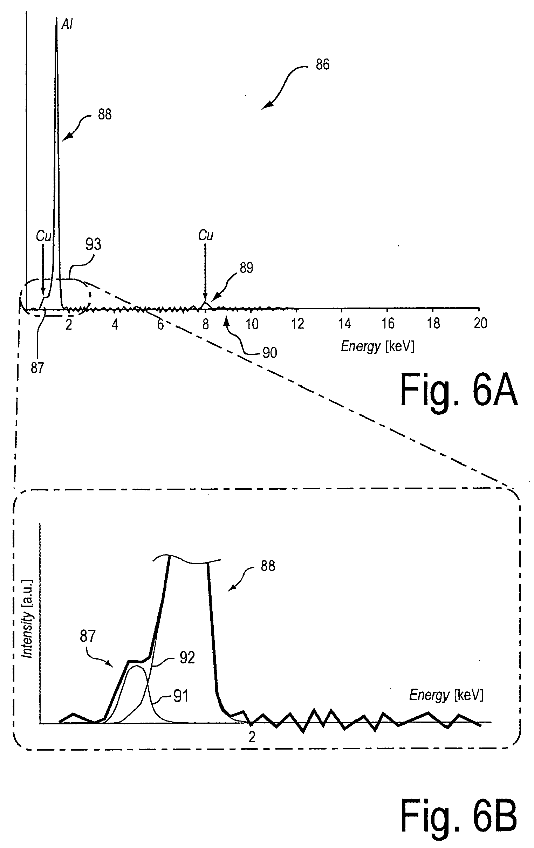

A further beneficial effect of using the object composition list in the compositional analysis of the local spectral data sets is discussed in the following with reference to FIGS. 6A and 6B. FIG. 6A shows a graphical representation 86 of the local spectral data set of a third measurement region after background correction. FIG. 6B is a magnified view of a portion 93 of FIG. 6A.

The third measurement region has a comparatively low content of copper. Therefore, the emission line peaks 87 and 89, which are caused by copper, are comparatively small. Specifically, the copper peak 87 is overlapped with the much stronger emission line 88 of alumina so that the copper peak 87 appears as a shoulder of the alumina emission line 88. Furthermore, copper peak 89, is only just above the noise level and is distorted by noise.

However, since the compositional analysis of the energy spectrum of the third measurement region is limited to the elements alumina, copper and carbon, it can be concluded that a shoulder on the low-energy side of the alumina emission line 88 and a small peak at 8 keV indicates a contribution of copper. Since the compositional analysis of the local spectral data set of the third measurement region is limited to the elements of the object composition list, no test is performed for determining the presence of other elements, which may generate a shoulder in the low-energy side of the alumina emission line.

Thereby, it is possible to avoid errors which may occur in the compositional analysis as a result of the low magnitude peaks 87 and 89.

On the other hand, as can be seen in the upper portion of FIG. 4, the combined spectral data contains strong copper emission lines which clearly indicate that copper is present. The stronger copper lines in the combined spectral data compared to the local spectral data set of the third measurement region can be attributed to the fact that the combined spectral data are based on a higher number of counts, which increases the signal-to-noise ratio. Further, the combined spectral data is also determined based on measurement regions, which have a comparatively high content of copper, such as the first measurement region, which is shown in the lower part of FIG. 4.

Therefore, for each of the measurement regions, qualitative compositional information can be obtained having a higher accuracy and reliability.

The data analysis system is further configured to determine for each of the local data sets a quantitative compositional information based on the background corrected local spectral data sets of the measurement regions and based on the qualitative compositional information.

The quantitative analysis includes matrix correction, such as ZAF correction. The ZAF correction accounts for differences in the atomic number (Z) of the elements, the absorption factor (A) of the X-rays traveling through the material, and fluorescence (F) of X-rays from elements stimulating the emission of X-rays from other elements. Alternatives to ZAF correction are the phi-rho-z method or the phi-ZAF method.

Summarizing the above disclosure, a method and a system is provided which allows efficient X-ray or cathodoluminescence microanalysis inspection of samples. The inspection routines can be advantageously applied in the field of geoscience (such as environmental geoscience and forensic geoscience), archaeology, forensic analysis (such as analysis of gunshot residues or paint flakes), and analysis of airborne particulate materials.

## Claims

**1.** A method of operating a system (1), wherein the system (1) comprises a data analysis system (4) for interactively generating elemental local composition data of an object (10) depending on photon radiation data acquired by using a charged particle microscope (2); wherein the method comprises:

reading and/or generating, by the data analysis system (4), a plurality of local spectral data sets, each being indicative of an energy spectrum of photon radiation emitted in response to irradiation by a charged particle beam (21) generated by the charged particle microscope (2);
wherein each of the local spectral data sets represents a measurement performed in a respective measurement region of the object (10), wherein the measurement regions of the local spectral data sets are mutually non-identical;
combining two or more of the plurality of local spectral data sets to obtain combined spectral data and determining processing parameter data depending on at least a portion of the combined spectral data;
determining, for each of a number of the measurement regions, separate local composition data, depending on at least a portion of the local spectral data set of the respective measurement region; and
wherein the composition data of the local spectral data sets are further determined depending on the processing parameter data.

**2.** The method of claim 1, wherein the processing parameter data are indicative of one or more elements.

**3.** The method of claim 2, wherein the determining of the local composition data comprises using the one or more elements as a list of candidates.

**4.** The method of any one of the preceding claims, wherein the processing parameter data are indicative of at least one energy value and/or at least one energy range.

**5.** The method of claim 4, wherein each of the at least one energy value and/or at least one energy range is substantially free from emission line peaks of the combined spectral data.

**6.** The method of any one of the preceding claims, wherein for each of the number of measurement regions, the determining of the local composition data comprises:

determining a background estimate for a background correction for at least one or more emission line peaks of the local spectral data set of the respective measurement region, depending on at least a respective portion of the processing parameter data.

**7.** The method of claim 6, wherein the background estimate is determined depending on one or more spectrum data points of the local spectral data set of the respective measurement region;
wherein the spectrum data points are determined using at least the respective portion of the processing parameter data.

**8.** The method of any one of the preceding claims, wherein the method further comprises:

acquiring image data of a surface region of the object (10); and
identifying a portion of the surface region depending on the acquired image data;

wherein the combining of the local spectral data sets is performed substantially limited to local spectral data sets acquired within the portion of the surface region.

**9.** The method of claim 8, wherein the identifying of the portion of the surface area of the object (10) is performed depending on a compositional contrast of the image data.

**10.** A computer program product comprising a machine-readable medium having stored thereon a program code which, when loaded and executed in a computer system, is adapted to perform the method according to any one of the preceding claims.

**11.** A system (1) comprising a data analysis system (4) for interactively generating local composition data of an object (10) depending on photon radiation data acquired by using a charged particle microscope (2);
wherein the data analysis system (4) is configured for interactively or automatically
reading and/or generating a plurality of local spectral data sets, each of which being indicative of an energy spectrum of photon radiation emitted in response to irradiation by a charged particle beam (21) generated by the charged particle microscope (2);
wherein each of the local spectral data sets represents a measurement performed in a respective measurement region of the object (10), wherein the measurement regions of the local spectral data sets are mutually non-identical, combining two or more of the plurality of local spectral data sets to obtain combined spectral data;
determining processing parameter data depending on at least a portion of the combined spectral data;
determining, for each of a number of the measurement regions, separate local composition data, depending on at least a portion of the local spectral data set of the respective measurement region; and
wherein the composition data of the local spectral data sets are further determined depending on the processing parameter data.

**12.** The system of claim 11, further comprising a graphical user interface configured for interactive determination of the processing parameter data.

**13.** The system (1) of claim 11 or 12, wherein the data analysis system (4) further comprises a graphical user interface, which is configured to display a graphical representation (71) of at least a portion of the combined spectral data in graphical relation to a graphical representation (73, 74, 75) generated depending on at least a portion of the processing parameter data.

**14.** The system (1) of any one of claims 11 to 13, wherein the system (1) is further configured for
interactively or automatically identifying a portion of a surface region of the object (10) depending on image data of the surface region of the object (10);
wherein the data analysis system (4) is configured so that the combining of the local spectral data sets is substantially limited to local spectral data sets acquired within the portion of the surface region.

**15.** The system (1) of any one of claims 11 to 14, wherein the system further includes a particle beam microscope;
wherein the particle beam microscope is configured to irradiate the measurements regions with the charged particle beam and to detect the photon radiation emitted in response to the irradiation with the charged particle beam.

1
2
20
4
43
22
25
52
23
42
CPU
10
21
50
44
26
27

Fig. 1

60
61
62
64
66
65

Fig. 2

30
34
33
31
37
35
36
Intensity
0
2
4
6
8
10
Energy keV

Fig. 3

71
83
Al
Cu
82
C
81
80
Cu
73
74
75
Cu
84
Intensity [a.u.]
2
4
6
8
10
12
14
16
18
20
Energy [keV]
79
Cu
Cu
72
Cu
Intensity [a.u.]
76
77
78
94
2
4
6
8
10
12
14
16
18
Energy [keV]
70


Fig. 4

Al
82
Intensity [a.u.]
83
84
85
81
2
4
6
8
10
12
14
16
18
20
Energy [keV]

Fig. 5

Al
86
88
Cu
93
Cu
89
2
4
6
8
10
12
14
16
18
20
Energy [keV]
90
87
88
Intensity [a.u.]
87
92
91
Energy [keV]
2

Fig. 6A

Fig. 6B

Europäisches Patentamt
European Patent Office
Office européen des brevets

# EUROPEAN SEARCH REPORT

Application Number
EP 16 00 0567

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (IPC) |
| E | EP 3 062 096 A1 (FEI CO [US]) 31 August 2016 (2016-08-31)<br>* paragraphs [0004] - [0007], [0015] - [0021], [0025] - [0032], [0035], [0036], [0038] - [0048]; claims 1,4; figures 2-4, 7-10 *<br>----- | 1-4,8, 10-12, 14,15 | INV.<br>H01J37/28<br>G01N23/225 |
| X<br>Y | US 2008/027657 A1 (ROHDE DAVID B [US] ET AL) 31 January 2008 (2008-01-31)<br>* paragraphs [0004] - [0009], [0012] - [0023], [0026] - [0029]; figures *<br>----- | 1-4, 10-13,15<br>4-9,14 | |
| X<br>Y | US 6 675 106 B1 (KEENAN MICHAEL R [US] ET AL) 6 January 2004 (2004-01-06)<br>* column 5, line 8 - column 6, line 40; figures 1-4 *<br>* column 7, line 41 - column 8, line 54; figures 4, 5 *<br>* column 8, line 58 - column 19, line 48; figures 6-9 *<br>----- | 1,4-7<br>4-7 | |
| | | | TECHNICAL FIELDS SEARCHED (IPC) |
| A | JP 4 506524 B2 (SHIMADZU CORP) 21 July 2010 (2010-07-21)<br>* abstract; figures *<br>* paragraphs [0006] - [0009], [0018] - [0022] *<br>----- | 4-7 | H01J<br>G01N |
| Y | EP 2 546 638 A2 (FEI CO [US]) 16 January 2013 (2013-01-16)<br>* paragraphs [0053] - [0059] *<br>----- | 8,9,14 | |
| A | US 2015/122992 A1 (OWEN MICHAEL JAMES [AU] ET AL) 7 May 2015 (2015-05-07)<br>* paragraphs [0031] - [0042], [0051] - [0054]; figures *<br>-----<br>-/-- | 1,10,11, 15 | |

The present search report has been drawn up for all claims

2

| Place of search | Date of completion of the search | Examiner |
|---|---|---|
| Munich | 14 November 2016 | Schmidt-Kärst, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 16 00 0567

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP H11 271246 A (JEOL LTD) 5 October 1999 (1999-10-05) * abstract; figures * * paragraphs [0003] - [0008], [0015] - [0028] * ----- | 4-7 | |
| | | | TECHNICAL FIELDS SEARCHED (IPC) |

The present search report has been drawn up for all claims

| Place of search | Date of completion of the search | Examiner |
|---|---|---|
| Munich | 14 November 2016 | Schmidt-Kärst, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

2

EPO FORM 1503 03.82 (P04C01)

page 2 of 2

Europäisches
Patentamt
European
Patent Office
Office européen
des brevets

Application Number

EP 16 00 0567

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

# LACK OF UNITY OF INVENTION SHEET B

Application Number
EP 16 00 0567

The Search Division considers that the present European patent application does not comply with the requirements of unity of invention and relates to several inventions or groups of inventions, namely:

1. claims: 1-3, 8-15(completely); 4(partially)

System comprising a data analysis system for interactively generating local composition data of an object depending on photo radiation acquired by using a charged particle microscope, as well as method of operating said system, comprising, inter alia, the steps of
- combining at least two local spectral data sets and determining processing parameter data depending on the combined spectral data,
- determining local composition data, depending on at least a portion of the respective local spectral data and further on the processing parameter data,
- wherein the processing parameter data are indicative of one or more elements.

1.1. claims: 8, 9, 14

System comprising a data analysis system for interactively generating local composition data of an object depending on photo radiation acquired by using a charged particle microscope, as well as method of operating said system, comprising, inter alia, the steps of
- combining at least two local spectral data sets and determining processing parameter data depending on the combined spectral data,
- determining local composition data, depending on at least a portion of the respective local spectral data and further on the processing parameter data,
further comprising the steps of,
- acquiring image data of a surface region of the object ; and
- identifying a portion of the surface region depending on the acquired image data,
- wherein the combining of the local spectral data sets is performed substantially limited to local spectral data sets acquired within the portion of the surface region.

---

2. claims: 5-7(completely); 4(partially)

System comprising a data analysis system for interactively generating local composition data of an object depending on photo radiation acquired by using a charged particle microscope, as well as method of operating said system, comprising, inter alia, the steps of
- combining at least two local spectral data sets and determining processing parameter data depending on the combined spectral data,
- determining local composition data, depending on at least a portion of the respective local spectral data and further

page 1 of 2

Europäisches Patentamt
European Patent Office
Office européen des brevets

## LACK OF UNITY OF INVENTION SHEET B

Application Number
EP 16 00 0567

The Search Division considers that the present European patent application does not comply with the requirements of unity of invention and relates to several inventions or groups of inventions, namely:

on the processing parameter data,
- wherein the processing parameter data are indicative of at least one energy value and/or at least one energy range which is substantially free from emission line peaks of the combined spectral data and thus adapted to determine a background estimate.

---

Please note that all inventions mentioned under item 1, although not necessarily linked by a common inventive concept, could be searched without effort justifying an additional fee.

## ANNEX TO THE EUROPEAN SEARCH REPORT ON EUROPEAN PATENT APPLICATION NO. EP 16 00 0567

This annex lists the patent family members relating to the patent documents cited in the above-mentioned European search report. The members are as contained in the European Patent Office EDP file on The European Patent Office is in no way liable for these particulars which are merely given for the purpose of information.

14-11-2016

| Patent document cited in search report | | Publication date | Patent family member(s) | | | Publication date |
|---|---|---|---|---|---|---|
| EP 3062096 | A1 | 31-08-2016 | NONE | | | |
| US 2008027657 | A1 | 31-01-2008 | EP | 2047245 | A2 | 15-04-2009 |
| | | | JP | 5286598 | B2 | 11-09-2013 |
| | | | JP | 2009544980 | A | 17-12-2009 |
| | | | US | 2008027657 | A1 | 31-01-2008 |
| | | | WO | 2008014463 | A2 | 31-01-2008 |
| US 6675106 | B1 | 06-01-2004 | NONE | | | |
| JP 4506524 | B2 | 21-07-2010 | JP | 4506524 | B2 | 21-07-2010 |
| | | | JP | 2006258633 | A | 28-09-2006 |
| EP 2546638 | A2 | 16-01-2013 | CN | 102879407 | A | 16-01-2013 |
| | | | EP | 2546638 | A2 | 16-01-2013 |
| | | | EP | 2605005 | A1 | 19-06-2013 |
| | | | JP | 2013019900 | A | 31-01-2013 |
| | | | US | 2013015351 | A1 | 17-01-2013 |
| US 2015122992 | A1 | 07-05-2015 | AU | 2014346694 | A1 | 19-05-2016 |
| | | | US | 2015122992 | A1 | 07-05-2015 |
| | | | WO | 2015069879 | A1 | 14-05-2015 |
| JP H11271246 | A | 05-10-1999 | JP | 3547310 | B2 | 28-07-2004 |
| | | | JP | H11271246 | A | 05-10-1999 |

EPO FORM P0459

For more details about this annex : see Official Journal of the European Patent Office, No. 12/82